Europäisches Patentamt

European Patent Office

Office européen des brevets

(11) Numéro de publication : **0 399 923 B1**

# (12) FASCICULE DE BREVET EUROPEEN

(45) Date de publication du fascicule du brevet :
**06.04.94 Bulletin 94/14**

(51) Int. Cl.$^5$ : **G01R 27/18, H02H 3/17**

(21) Numéro de dépôt : **90420226.4**

(22) Date de dépôt : **15.05.90**

(54) **Procédé de correction du déphasage introduit par un tore homopolaire de mesure d'un courant de fuite.**

(30) Priorité : **22.05.89 FR 8906769**

(43) Date de publication de la demande :
**28.11.90 Bulletin 90/48**

(45) Mention de la délivrance du brevet :
**06.04.94 Bulletin 94/14**

(84) Etats contractants désignés :
**BE CH DE ES GB IT LI SE**

(56) Documents cités :
**DE-B- 2 542 811**
**PATENT ABSTRACTS OF JAPAN vol. 7, no.**
**241 (P-232)(1386) 26 octobre 1983, & JP-A-58**
**127173**

(56) Documents cités :
**PATENT ABSTRACTS OF JAPAN vol. 12, no.**
**453 (P-792)(3300) 29 novembre 1988, & JP-A-63**
**175772**
**PATENT ABSTRACTS OF JAPAN vol. 12, no.**
**492 (P-804)(3339) 22 décembre 1988, & JP-A-63**
**204161**

(73) Titulaire : **MERLIN GERIN**
**2, chemin des Sources**
**F-38240 Meylan (FR)**

(72) Inventeur : **Suptitz, Eric**
**Merlin Gerin- Sce. Brevets**
**F-38050 Grenoble Cédex (FR)**

(74) Mandataire : **Hecke, Gérard et al**
**Merlin Gérin, Sce. Propriété Industrielle**
**F-38050 Grenoble Cédex 9 (FR)**

## Description

L'invention est relative à un procédé et appareil de mesure d'un courant de fuite utilisant un transformateur différentiel de détection, et un générateur d'injection d'un signal alternatif de référence.

Un procédé de mesure connu consiste à :
- injecter en permanence un signal alternatif de référence entre le réseau et la terre,
- prélever un signal de mesure Vd fonction du courant de fuite Id circulant dans l'impédance de fuite Zd aux bornes d'un enroulement de mesure d'un transformateur différentiel à tore entourant les conducteurs du réseau,
- analyser le signal de mesure en phase et en amplitude par détection synchrone pour faire la discrimination entre les composantes résistive et capacitive,
- calculer et à afficher les valeurs individuelles de la résistance de fuite R et de la capacité C parasite du réseau responsables du courant de fuite Id. Un tel procédé ressort du document FR-A 2.616.228.

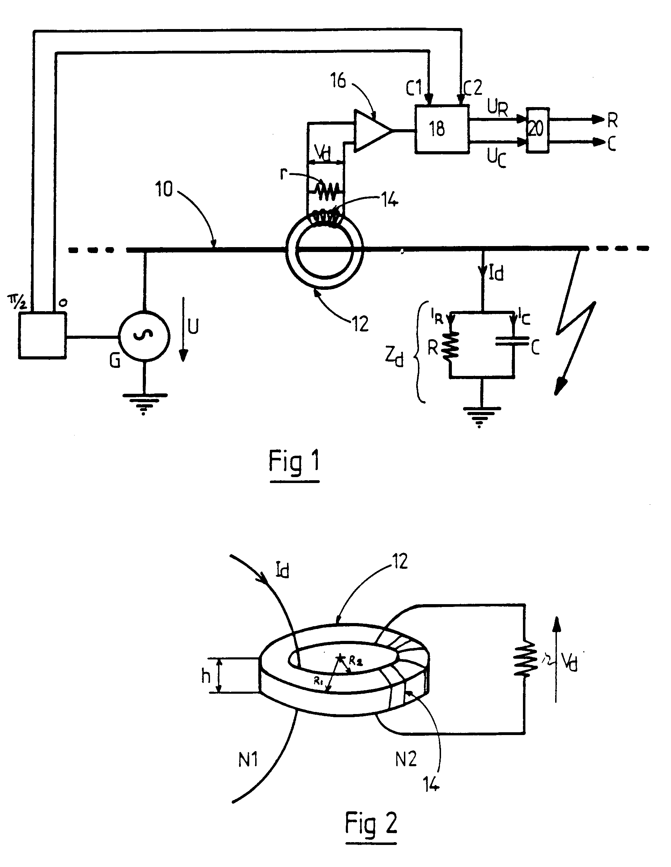

Le contrôle de l'isolement d'un réseau électrique de distribution s'opère par l'analyse du courant de fuite Id circulant dans l'impédance de fuite Zd, laquelle est composée d'une résistance de fuite R connectée en parallèle sur une capacité parasite C (voir figure 1 de l'art antérieur). Le courant de fuite Id est créé par un générateur G qui injecte en permanence sur le réseau 10, par l'intermédiaire d'un filtre, un signal alternatif de référence, ayant une tension U dont la fréquence est inférieure à celle du réseau 10. La fréquence d'injection choisie est inférieure à la fréquence du réseau afin de limiter l'influence de la capacité parasite C. La résistance de fuite R correspond au défaut réel d'isolement, et la capacité C correspond aux capacités parasites des lignes du réseau 10. L'impédance capacitive $1/C\omega$ est généralement très supérieure à la résistance R que l'on se propose de mesurer pour en déduire le niveau d'isolement. Pour isoler la composante résistive Ir, il est nécessaire de pouvoir mesurer avec une grande précision le déphasage entre le courant de fuite Id et la tension U injectée du signal de référence. La précision doit être de l'ordre de la minute d'angle.

Selon la figure 1, la mesure du courant de fuite Id s'effectue au moyen d'un transformateur différentiel à tore 12 homopolaire entourant les conducteurs du réseau 10. Le signal de mesure Vd engendré aux bornes d'une résistance de charge r connectée en parallèle sur l'enroulement de mesure 14, est appliqué à un amplificateur 16, puis analysé par un dispositif détecteur synchrone 18 lequel est piloté par des signaux de commande C1 et C2 respectivement en phase et en quadrature de phase avec la tension U injectée. Le fonctionnement du dispositif détecteur synchrone 18 est bien connu des spécialistes, et ressort du document précité FR-A 2.616.228.

La sortie du dispositif détecteur synchrone 18 délivre deux signaux de tension UR et UC respectivement proportionnels à la résistance de fuite R, et à l'impédance capacitive $1/C\omega$. Un dispositif de calcul et d'affichage 20 indique alors les valeurs de la résistance de fuite R et de la capacité C parasite. Ces valeurs seraient vraies, si le transformateur différentiel à tore 12 était parfait. La technologie actuelle des transformateurs différentiels permet d'obtenir une précision assez bonne sur l'amplitude du signal délivré par l'enroulement de mesure 14. Par contre la précision sur la mesure en phase du courant de fuite est moins bonne. Cette différence de précision s'explique par le fait que l'erreur commise sur l'amplitude du courant de fuite est fonction de la perméabilité magnétique du matériau du tore 12 au second ordre seulement, alors que l'erreur sur la mesure en phase est fonction en premier ordre de cette même perméabilité qui varie avec la température. Il en résulte que le transformateur différentiel à tore 12 introduit un déphasage "A" supplémentaire entre le courant de fuite Id, et la tension secondaire du signal de mesure Vd de l'enroulement de mesure 14. Ce déphasage A fausse les valeurs de R et C affichées par le dispositif 20 de la figure 1. Outre l'influence de la température sur la perméabilité, on a constaté de plus que le déphasage A est fonction de l'intensité du courant de fuite Id. Ces différents paramètres provoquent une fluctuation dans le temps du déphasage A qui affecte la précision de la mesure. Cette fluctuation du déphasage est imprévisible, et donc très difficile à modéliser.

Il a déjà été proposé d'améliorer la précision de mesure en disposant un condensateur en parallèle sur l'enroulement secondaire 14 du tore 12 pour former un circuit oscillant accordé sur la fréquence de la tension injectée U. La précision de mesure du déphasage est alors de l'ordre de cinq minutes d'angle, ce qui n'est pas compatible avec la très grande précision de déphasage requise avec un dispositif détecteur synchrone.

Selon une autre technique connue, tous les paramètres du tore 12 sont stockés dans une mémoire d'un contrôleur d'isolement équipé d'un processus à traitement numérique. La complexité des séquences du logiciel mis en oeuvre pour tenir compte individuellement de ces paramètres dans le calcul de la résistance de fuite R et de la capacité C, rallonge le temps de traitement du programme, et ne permet cependant pas d'obtenir les performances nécessaires.

Dans le document Patent Abstracts of Japan, Vol. 12, n° 453 du 22 décembre 1988 correspondant à la demande de brevet japonais JP-A-63.175.772, un enroulement additionnel est prévu sur le tore d'un contrôleur d'isolement pour l'injection d'un signal de référence de phase. La présence de ce circuit spécial complique le procédé de mesure de l'isolement.

Un premier objet de l'invention consiste à réaliser un procédé simple de correction du déphasage pour améliorer la précision de mesure d'un courant de fuite détecté par un transformateur différentiel.

Le procédé est caractérisé par les étapes intermédiaires suivantes :

- on mesure la tension à vide, et la tension en charge du signal de mesure Vd délivré par le transformateur différentiel,
- on détermine en ligne le déphasage introduit par le tore entre le courant de fuite Id et le signal de mesure Vd, en faisant la division de l'amplitude de la tension en charge par l'amplitude de la tension à vide, permettant d'obtenir un rapport assimilé à la tangente de l'angle de déphasage,
- on effectue au moyen dudit rapport une correction de phase sur les composantes résistive et capacitive pour obtenir la phase réelle du courant de fuite Id, ainsi que les valeurs vraies de la résistance de fuite R, et de la capacité C parasite.

Les équations de modélisation d'un tore démontrent que la tension du signal de mesure Vd aux bornes de la résistance de charge r (voir figure 2) a pour expression :

$$(1) \qquad Vd = (jL2\omega/r + jL2\omega). \, r \, (N1/N2) \, Id$$

L2 étant l'inductance de l'enroulement de mesure 14 proportionnel au carré de N2,

et N1 et N2 étant le nombre de spires primaire et secondaire du tore 12.

La mesure en charge fait apparaître que la tangente de l'angle de déphasage entre le courant Id et la tension du signal de mesure Vd d'une part, et le module de la tension d'autre part Vd ont respectivement pour expression :

$$(2) \qquad tg \, A = r/L2.\omega$$

$$(3) \qquad \| \, Vd \, \| = (N1/N2) \, \|Id\|. \, rL2.\omega/\sqrt{r^2 + (L2.\omega)^2}$$

On remarque d'autre part que le module de la tension à vide, et le module de la tension en charge du signal de mesure Vd sont représentés par les formules suivantes :

$$(4) \qquad \| \, Vd \, vide \, \| \simeq L2 \, \omega \, N1 \, .\|Id\| \, /N2$$

$$(5) \qquad \| \, Vd \, charge \, \| \simeq r \, N1. \, \|Id\| \, / \, N2$$

Il résulte des relations (4) et (5) que le rapport des modules de la tension, en charge sur la tension à vide du signal de mesure Vd est assimilé à la valeur de la tangente de l'angle de déphasage A définie à la relation (2). D'où la relation suivante :

$$(6) \qquad \| \, Vd \, charge \, \|/\| \, Vd \, vide \, \| \simeq tg \, A = r \, / \, L2\omega \, .$$

Il suffit en conséquence de faire la division entre les amplitudes de la tension en charge, et de la tension à vide du signal de mesure Vd pour déterminer la tangente de l'angle déphasage A.

La division des amplitudes des tensions en charge et à vide du signal de mesure du transformateur différentiel est opérée périodiquement de manière à obtenir une évolution dans le temps de l'angle de déphasage.

La détection synchrone est opérée au moyen de deux signaux de commande C1 et C2 en quadrature de phase, l'un des signaux C1 étant en phase avec le signal alternatif de référence injecté. La correction de phase s'effectue après la détection synchrone par une rotation d'angle des composantes résistive et capacitive.

Cette correction de phase dépend de la relation suivante :

$$(7) \qquad \begin{bmatrix} UR1 \\ UC1 \end{bmatrix} = \begin{bmatrix} \cos A & -\sin A \\ \sin A & \cos A \end{bmatrix} \begin{bmatrix} UR \\ UC \end{bmatrix}$$

UR et UC représentent les valeurs erronées des deux signaux de tension délivrés par le dispositif synchrone 18, UR1 et UC1 étant les valeurs vraies après la correction de phase de UR et UC. La rotation d'angle A étant très petite (de l'ordre de 1 à 2 degrés).

On peut par appoximation considérer que

cos A = 1

et

sin A = tg A

Il en résulte les relations simplifiées suivantes :

EP 0 399 923 B1

$$(8) \quad \begin{bmatrix} UR1 \\ UC1 \end{bmatrix} = \begin{bmatrix} 1 & -tg\ A \\ tg\ A & 1 \end{bmatrix} \begin{bmatrix} UR \\ UC \end{bmatrix}$$

d'où les relations :

$$(9) \quad UR1 = UR + UC\ tg\ A$$
$$(10) \quad UC1 = UC - UR\ tg\ A$$

qui définissent le procédé de correction de phase.

La correction de phase s'effectue en additionnant à la composante résistive du signal de mesure une première grandeur corrigée correspondant au produit de la composante capacitive dudit signal de mesure par la tangente de l'angle de déphasage A.

La correction d'angle s'opère en retranchant de la composante capacitive du signal de mesure après détection synchrone, une deuxième grandeur corrigée correspondant au produit de la composante résistive dudit signal de mesure par la tangente de l'angle de déphasage A.

Un deuxième objet de l'invention consiste à réaliser un contrôleur d'isolement fiable utilisant le procédé de correction du déphasage précité.

Selon un premier mode de réalisation le contrôleur d'isolement comporte un circuit électronique à composants analogiques utilisant les relations 6, 9 et 10 précitées.

Selon un deuxième mode de réalisation, le contrôleur d'isolement comporte un circuit électronique numérique.

D'autres avantages et caractéristiques ressortiront plus clairement de la description qui va suivre des deux modes de réalisation de l'invention, donnés à titre d'exemples, et représentés aux dessins annexés, dans lesquels :

- la figure 1 représente le schéma synoptique d'un contrôleur d'isolement selon l'art antérieur;
- la figure 2 montre la structure d'un transformateur différentiel à tore;
- la figure 3 montre le schéma synoptique d'un contrôleur d'isolement analogique selon l'invention;
- la figure 4 représente le schéma synoptique d'un contrôleur d'isolement numérique selon l'invention.

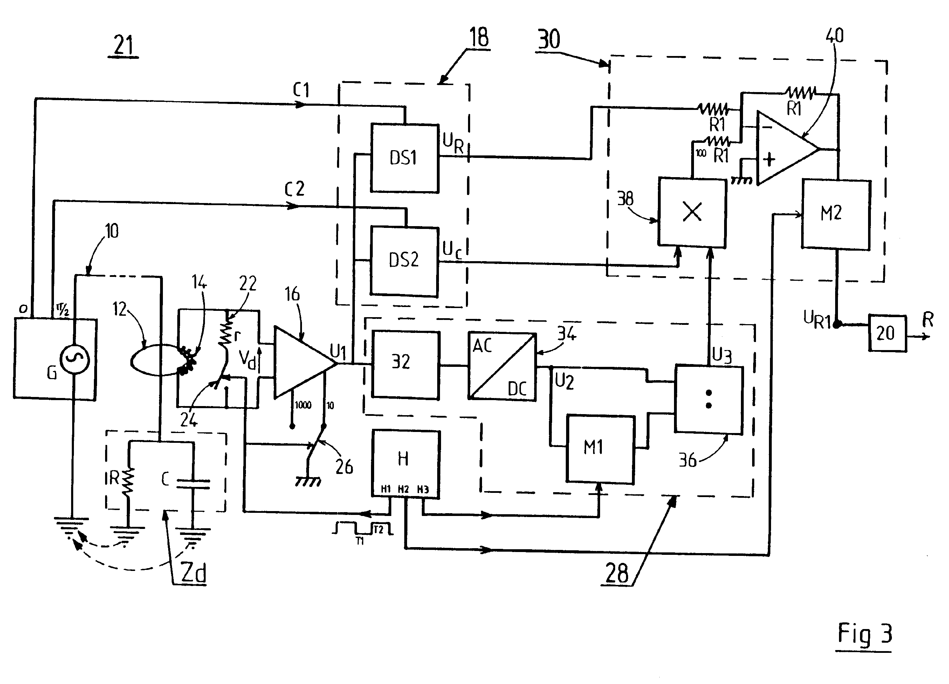

Dans le contrôleur d'isolement 21 analogique à la figure 3, les mêmes repères seront utilisés pour désigner des composants identiques ou similaires à ceux du dispositif connu de la figure 1. A l'enroulement de mesure 14 du tore 12 est connecté en parallèle un circuit de mesure 22 comprenant la résistance de charge r en série avec un premier interrupteur 24 statique. Le signal de mesure Vd est amplifié dans l'amplificateur 16 avec des possibilités de gain, dont l'un est élevé (environ 1000), et l'autre est faible (environ 10). La programmation du gain de l'amplificateur 16 est gérée par un deuxième interrupteur 26 statique. Un compteur H délivre un premier signal d'horloge H1 ayant des alternances de durée T1, T2 vers les deux interrupteurs 24, 26 statiques, et deux autres signaux d'horloge H2 et H3 pour la commande de circuits à mémoires M1 et M2.

La sortie de l'amplificateur 16 est connectée d'une part à l'entrée du dispositif détecteur synchrone 18 ayant deux circuits de détection synchrone DS1 et DS2 pilotés par des signaux de commande C1 et C2 et d'autre part à un circuit de calcul 28 de la tangente du déphasage A entre le courant à fuite Id et la tension du signal de mesure Vd.

Un circuit de compensation 30 coopère avec le circuit de calcul 28 et les deux circuits de détection synchrone DS1, DS2 pour corriger le déphasage A introduit en ligne par le tore 12.

Le circuit de calcul 28 comporte un filtre 32 à capacités commutées éliminant la fréquence (50 Hz ou 60 Hz) du réseau, et relié en série avec un convertisseur 34 alternatif - continu renfermant un redresseur et un filtre de lissage. La sortie du convertisseur 34 est branchée d'une part, à un premier circuit à mémoire M1 formé par un échantillonneur - bloqueur piloté par le troisième signal d'horloge H3, et d'autre part à un circuit diviseur 36 qui délivre au circuit de compensation 30 un signal de sortie U3 représentatif de la tangente de l'angle de déphasage A.

Le circuit de compensation 30 est équipé d'un circuit multiplicateur 38 qui reçoit le signal de sortie U3 du circuit diviseur 36, et le signal de tension UC du circuit de détection synchrone DS2. Un circuit additionneur 40 est connecté aux sorties du circuit multiplicateur 38 et du circuit de détection synchrone DS1 de manière à délivrer le signal de tension UR1 après mémorisation dans le circuit à mémoire M2.

Le fonctionnement du contrôleur d'isolement analogique selon la figure 3 est le suivant :

Pendant l'intervalle de temps T1 du premier signal d'horloge H1, intervient la première phase de mesure à vide après déconnexion de la résistance de charge r, suite à l'ouverture du premier interrupteur 24 statique. La tension du signal de mesure Vd du transformateur différentiel est amplifiée par l'amplificateur 16 programmé

4

sur le gain faible (x 10) par le deuxième interrupteur 26. La tension de sortie U1 de l'amplificateur 16 est filtrée dans le filtre 32 pour s'affranchir des parasites à 50 Hz de la fréquence du réseau, puis est convertie par le convertisseur 34 en un signal de tension continue U2. Le signal U2 est représentatif de la tension à vide du signal de mesure Vd, et est mémorisé dans le premier circuit à mémoire M1.

La deuxième phase de mesure en charge intervient pendant le second intervalle de temps T2 du premier signal d'horloge H1. La résistance de charge r est alors connectée aux bornes de l'enroulement de mesure 14 du tore 12 après fermeture du premier interrupteur 24 statique. Le signal de tension Vd est amplifié par l'amplificateur 16 programmé au gain élevé (x 1000) par le deuxième interrupteur 26 statique, étant donné que la tension en charge est environ cent fois plus faible que la tension à vide. La tension de sortie U1 est convertie par le convertisseur 34 en un signal de tension continue U2, tel que décrit précédemment. Parallèlement, la tension U1 est appliquée aux deux circuits de détection synchrone DS1, DS2, délivrant respectivement des signaux de tension continue UR et UC, lesquels sont pollués par le déphasage A introduit par le transformateur différentiel. Durant cette dernière phase de mesure, le signal de tension continue U2 est représentatif de la tension en charge du signal de mesure Vd, qui est introduite au numérateur du circuit diviseur 36. La tension à vide mémorisée dans le premier circuit à mémoire M1 pendant l'intervalle de temps T1 précédent T2 est ensuite injectée au dénominateur du circuit diviseur 36. La tension U3 du circuit diviseur 36 est proportionnelle au déphasage A et représente en fait 100 tg A. Après multiplication dans le circuit multiplicateur 38 des tensions U3 et UC, et par addition dans le circuit additionneur 40 de ce résultat, atténué cent fois avec la tension UR, on obtient la tension vraie UR1 en sortie du circuit additionneur 40 après correction de phase de la tension UR. La tension UR1 satisfait la relation (9) précitée (UR1 = UR + UC tg A) et est directement proportionnelle à la résistance de fuite R, indépendamment des variations du déphasage A liées aux paramètres du tore 12.

Il est également possible d'isoler la composante UC1 pour déterminer la capacité parasite C du réseau. Les moyens de mise en oeuvre ne sont pas représentés sur la figure 3, mais découlent de la relation (10) précitée, (UC1 = UC - UR tg A). Il suffit en effet d'effectuer la multiplication des tensions UR et U3 dans un circuit multiplicateur, puis de soustraire le résultat à la tension UC.

Le signal de tension UR1 est mémorisé par le circuit à mémoire M2 qui conserve ainsi la dernière valeur mesurée pendant l'intervalle de temps T1 de la première phase de mesure à vide.

La tension UR1 est traitée dans le dispositif de calcul et d'affichage 20 qui indique directement la valeur vraie de la résistance de fuite R en ohms.

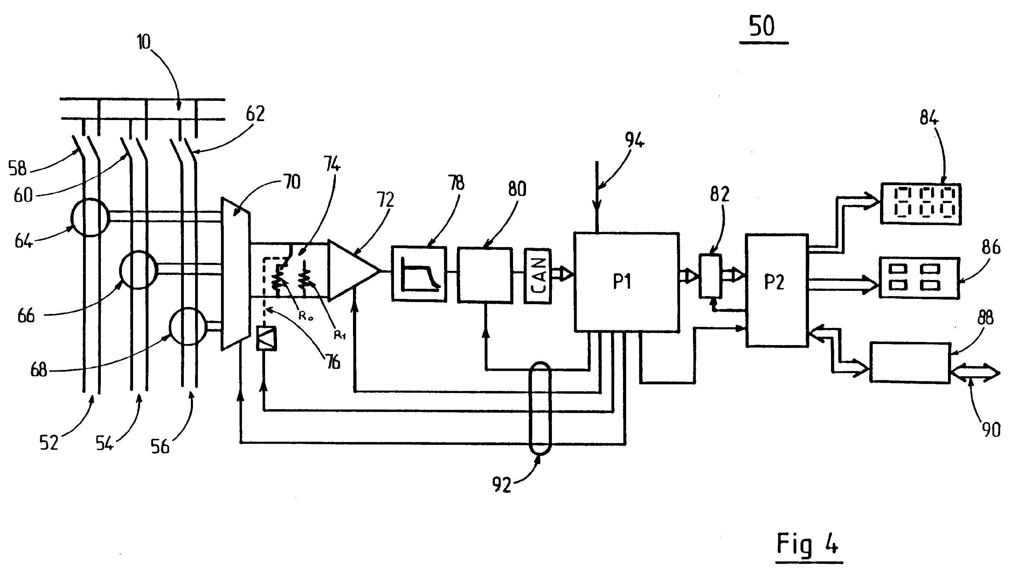

En référence à la figure 4, un contrôleur d'isolement numérique 50 est destiné à mesurer les résistances d'isolement dans plusieurs départs 52, 54, 56 d'un réseau 10 alternatif. Un circuit d'injection (non représenté) du contrôleur 50 injecte entre le réseau 10 et la terre un signal simusoidal à très basse fréquence (par exemple 10 Hz). Chaque départ 52, 54, 56 ... comporte un disjoncteur de tête 58, 60, 62, et un transformateur différentiel à tore 64, 66, 68 entourant les conducteurs actifs du départ. Le courant injecté se referme vers la terre par les impédances d'isolement des départs 52, 54, 56, situées en aval des tores 64, 66, 68.

Les enroulements de mesure des différents tores 64, 66, 68 sont reliés à un multiplexeur 70 analogique dont la sortie est connectée à un amplificateur 72 par l'intermédiaire d'un circuit de mesure 74. Ce dernier comporte un relais 76 de sélection d'une résistance à vide Ro et d'une résistance en charge R1. La sortie de l'amplificateur 72 est branchée à un processeur P1 de signal numérique par l'intermédiaire d'un filtre 78 anti-repliement de spectre, d'un circuit échantillonneur - bloqueur 80 et d'un convertisseur CAN analogique / numérique.

Le processeur P1 de signal est relié au moyen d'un verrou électronique 82 appelé latch à un micro contrôleur P2, lequel est associé à un indicateur 84 alphanumérique, un clavier 86 pour l'entrée des paramètres, et un interface 88 de communication avec un bus 90 extérieur.

Un bus interne 92 permet le pilotage par le processeur P1 du multiplexeur 70, du relais 76 de sélection, de l'amplificateur 72 et de l'échantillonneur bloqueur 80.

Le fonctionnement du contrôleur d'isolement 50 numérique selon la figure 4 est le suivant :

Par l'intermédiaire d'un conducteur 94, le processeur P1 reçoit un signal d'information du circuit d'injection (non représenté) pour connaître la référence de phase de signal injecté sur le réseau. Le processeur P1 coopère ensuite avec le multiplexeur 70 pour déclencher une mesure d'isolement sur l'un des départs 52, 54, 56. Le déroulement de cette mesure s'opère dans une première phase par la sélection du relais 76 sur la résistance à vide RO, suivi d'un échantillonnage du signal de mesure sur plusieurs périodes après réglage du gain de l'amplificateur 72. Le processeur P1 assure ensuite un filtrage numérique du signal numérisé pour éliminer les parasites et le bruit, puis détermine après démodulation synchrone les composantes résistive et capacitive du signal image de l'impédance de défaut mesuré par le tore en association avec la résistance à vide Ro.

Dans une deuxième phase, le processeur P1 sélectionne la résistance en charge R1 par le relais 76, et recommence la procédure précédente pour déterminer les nouvelles composantes en charge du signal issu du tore.

Dans une troisième phase, le processeur P1 de signal envoie au microcontrôleur P2 les valeurs des composantes obtenues à vide et en charge, ainsi que le gain respectif de l'amplificateur 72. Le processeur P1 de signal est alors prêt à effectuer une mesure sur un autre départ, alors que le microcontrôleur P2 calcule la tangente de l'angle de déphasage A introduit pas le tore correspondant, et les valeurs réelles de la résistance de fuite R et de la capacité C parasite du départ en utilisant les relations (6, 9 et 10) précédentes du procédé. Les valeurs de R et C sont alors signalées sur l'afficheur 84.

La précision de la mesure peut encore être améliorée par l'utilisation d'un ohmmètre (non représenté) destiné à coopérer avec le premier interrupteur 24 (fig.3), ou le relais 76 (fig.4) afin de mesurer la résistance électrique de l'enroulement de mesure 14 du tore 12,64,66,68 associé. Cette mesure additionnelle permet de s'affranchir des variations de résistance de l'enroulement de mesure 14 en fonction de la température.

## Revendications

1. Procédé de mesure d'un courant de fuite à la terre pour le contrôle de l'isolement d'un réseau de distribution électrique, consistant à :
   - injecter en permanence un signal alternatif de référence entre le réseau et la terre,
   - prélever un signal de mesure Vd fonction du courant de fuite Id circulant dans l'impédance de fuite Zd aux bornes d'un enroulement de mesure d'un transformateur différentiel à tore entourant les conducteurs du réseau,
   - analyser le signal de mesure en phase et en amplitude par détection ou démodulation synchrone pour faire la discrimination entre les composantes résistive et capacitive,
   - calculer et à afficher les valeurs individuelles de la résistance de fuite R et de la capacité C parasite du réseau responsables du courant de fuite Id,
   caractérisé par les étapes intermédiaires suivantes :
   - on mesure la tension à vide et la tension en charge du signal de mesure Vd délivré par le transformateur différentiel,
   - on détermine en ligne le déphasage introduit par le tore entre le courant de fuite Id et le signal de mesure Vd, en faisant la division de l'amplitude de la tension en charge par l'amplitude de la tension à vide permettant d'obtenir un rapport prédéterminé assimilé à la tangente de l'angle de déphasage,
   - on effectue au moyen dudit rapport une correction de phase sur les composantes résistive et capacitive pour obtenir la phase réelle du courant de fuite Id, ainsi que les valeurs vraies de la résistance de fuite R, et de la capacité C parasite.

2. Procédé de mesure selon la revendication 1 caractérisé en ce que la division des amplitudes des tensions en charge et à vide du signal de mesure du transformateur différentiel est opérée périodiquement de manière à mesurer une évolution dans le temps de l'angle de déphasage du tore.

3. Procédé de mesure selon la revendication 1 ou 2, caractérisé en ce que la détection synchrone est opérée au moyen de deux signaux de commande C1 et C2 en quadrature de phase, l'un des signaux C1 étant en phase avec le signal alternatif de référence injecté, et que la correction de phase s'effectue après la détection synchrone par une rotation d'angle des composantes résistive et capacitive.

4. Procédé de mesure selon l'une des revendications 1 à 3 caractérisé en ce que la correction de phase s'effectue en additionnant à la composante résistive du signal de mesure, une première grandeur corrigée correspondant au produit de la composante capacitive dudit signal de mesure par la tangente de l'angle de déphasage A.

5. Procédé de mesure selon l'une des revendications 1 à 3, caractérisé en ce que la correction d'angle s'opère en retranchant de la composante capacitive du signal de mesure après détection synchrone, une deuxième grandeur corrigée correspondant au produit de la composante résistive dudit signal de mesure par la tangente de l'angle de déphasage A.

6. Contrôleur d'isolement ayant un circuit électronique analogique pour la mise en oeuvre du procédé selon l'une des revendications 1 à 5, comprenant :
   - un générateur G d'injection d'un signal alternatif de référence entre le réseau et la terre,
   - un transformateur différentiel à tore (12) homopolaire ayant un enroulement de mesure (14) qui délivre un signal de mesure Vd proportionnel au courant de fuite Id circulant dans l'impédance de fuite Zd,
- un dispositif détecteur synchrone (18) pour faire la discrimination entre les composantes résistive et capacitive dudit signal de mesure,
- et un dispositif de calcul et d'affichage (20) qui indique les valeurs de la résistance de fuite R et de la capacité C parasite du réseau, caractérisé en ce que le circuit électronique analogique comporte de plus en combinaison :
- un circuit de mesure (22) connecté en parallèle aux bornes de l'enroulement de mesure 14 du tore (12), et comprenant une résistance de charge r coopérant avec un premier interrupteur statique (24) piloté par un compteur H, pour mesurer la tension à vide, et la tension en charge du signal de mesure Vd,
- un circuit de calcul de déphasage (28) faisant le rapport entre la tension en charge et la tension à vide pour déterminer la tangente de l'angle de déphasage A,
- et un circuit de compensation (30) coopérant avec le circuit de calcul de déphasage (28) et le dispositif détecteur synchrone (18) pour corriger le déphasage A introduit en ligne par le tore (12).

7. Contrôleur d'isolement selon la revendication 6, caractérisé en ce qu'un amplificateur (16) à gain variable est inséré entre le circuit de mesure (22) et un filtre (32) éliminant la fréquence du réseau, la programmation du gain étant effectué au moyen d'un deuxième interrupteur statique (26) piloté par le compteur H, et que le circuit de calcul de déphasage (28) comporte :
- un convertisseur (34) alternatif - continu intercalé entre le filtre (32) et une première entrée d'un circuit diviseur (36),
- et un premier circuit à mémoire M1 piloté par le compteur H et agencé entre la sortie du convertisseur (34) et une deuxième entrée d'un circuit diviseur (36), la sortie de ce dernier délivrant un signal U3 représentatif de la tangente de l'angle de déphasage A.

8. Contrôleur d'isolement selon la revendication 7, caractérisé en ce que le circuit de compensation (30) comprend :
- un circuit multiplicateur (38) sensible au signal de sortie U3 du circuit diviseur (36), et à la composante capacitive UC du dispositif de détection synchrone (18),
- un circuit additionneur (40) recevant le signal de sortie du circuit multiplicateur (38), et la composante résistive UR du dispositif de détection synchrone (18),
- et un deuxième circuit à mémoire M2 piloté par le compteur H pour mémoriser la composante résistive vraie UR1 après correction de phase.

9. Contrôleur d'isolement ayant un circuit électronique numérique pour la mise en oeuvre du procédé selon l'une des revendications 1 à 5, comportant un microcontrôleur P2 numérique pour déterminer la résistance de fuite R et la capacité parasite C d'un réseau à partir d'un signal de mesure issu d'un transformateur différentiel à tore (64, 66, 68) homopolaire,
caractérisé en ce que le circuit électronique numérique comporte :
- un circuit de mesure (74) équipé d'un relais (76) de sélection d'une résistance à vide R0 et d'une résistance en charge R1,
- un processeur P1 de signal pilotant le relais (76) pour effectuer une mesure à vide et en charge du signal délivré par le tore (64, 66, 68) suivi d'une démodulation synchrone,
- un verrou électronique (82) pour autoriser la transmission des données du processeur P1 vers le microcrontôleur lequel effectue le calcul de la tangente de l'angle de déphasage A introduit par ledit tore, et des valeurs vraies de la résistance de fuite R et de la capacité parasite C, le circuit de mesure (74) étant intercalé entre un circuit multiplexeur (70) analogique raccordé aux tores (64, 66, 68) de plusieurs départs (52, 54, 56), et un amplificateur (72) à gain variable relié au processeur P1 de signal par l'intermédiaire d'un filtre (78) anti-repliement de spectre, et d'un circuit échantillonneur bloqueur (80) associé à un convertisseur CAN analogique numérique.

10. Contrôleur d'isolement selon la revendication 9, caractérisé en ce que le circuit comporte un ohmmètre coopérant avec le relais (76) de sélection pour mesurer la résistance électrique de l'enroulement de mesure du transformateur différentiel (64,66,68) homopolaire associé.

EP 0 399 923 B1

**Patentansprüche**

1. Verfahren zur Messung eines Erdfehlerstroms zur Isolationsüberwachung in einem elektrischen Verteilernetz, bestehend aus
   - der kontinuierlichen Injizierung eines Wechselstrom-Referenzssignals zwischen Leitungsnetz und Erde,
   - der Erfassung eines Meßsignals Vd in Abhängigkeit vom über die Fehlerimpedanz Zd fließenden Fehlerstrom Id an den Klemmen einer Meßwicklung eines um die Netzleiter gelegten Differenzstrom-Ringkernwandlers,
   - der Auswertung der Phasenlage und Amplitude des Meßsignals durch synchrone Erfassung zur Bestimmung der Wirkkomponente und der kapazitiven Blindkomponente,
   - der Berechnung und Anzeige der dem Fehlerstrom Id zugrundeliegenden Einzelwerte für den ohmschen Fehlerwiderstand R und die Störkapazität C des Leitungsnetzes, gekennzeichnet durch folgende Zwischenstufen:
   - Messung der vom Differenzstromwandler gelieferten Spannung des Meßsignals Vd im Leerlauf und unter Last,
   - Bestimmung der durch den Ringkernwandler während des Betriebs verursachten Phasenverschiebung zwischen dem Fehlerstrom Id und dem Meßsignal Vd durch Division von Lastspannungsamplitude und Leerlaufspannungsamplitude zur Ermittlung einer Verhältnisgröße, die etwa dem Tangens des Phasenverschiebungswinkels entspricht,
   - Phasenkorrektur für die Wirkkomponente und die kapazitive Blindkomponente unter Verwendung der genannten Verhältnisgröße zur Ermittlung der tatsächlichen Phasenlage des Fehlerstroms Id sowie der tatsächlichen Werte für den Fehlerwiderstand R und die Störkapazität C.

2. Meßverfahren nach Anspruch 1, dadurch gekennzeichnet, daß die Division der Lastspannungsamplitude durch die Leeflaulspannungsamplitude periodisch erfolgt, um so eine Veränderung des Phasenverschiebungswinkels des Ringkernwandlers über die Zeit zu messen.

3. Meßverfahren nach Anspruch 1 oder 2, dadurch gekennzeichnet, daß die Synchronerfassung mit Hilfe von zwei um 90 Grad phasenverschobenen Steuersignalen C1 und C2 erfolgt, wobei eines der Signale C1 mit dem injizierten Wechselstrom-Referenzssignal in Phase liegt und die Phasenkorrektur nach der Synchronerfassung durch eine Winkelverschiebung zwischen Wirkkomponente und kapazitiver Blindkomponente erfolgt.

4. Meßverfahren nach einem der Ansprüche 1 bis 3, dadurch gekennzeichnet, daß die Phasenkorrektur durch Addition einer ersten Korrekturgröße entsprechend dem Produkt aus der kapazitiven Blindkomponente des genannten Signals und dem Tangens des Phasenverschiebungswinkels A zur Wirkkomponente des Meßsignals erfolgt.

5. Meßverfahren nach einem der Ansprüche 1 bis 3, dadurch gekennzeichnet, daß die Winkelkorrektur nach der Synchronerfassung durch Subtraktion einer zweiten Korrekturgröße entsprechend dem Produkt aus der Wirkkomponente des genannten Meßsignals und dem Tangens des Phasenverschiebungswinkels A von der kapazitiven Blindkomponente des Meßsignals erfolgt.

6. Isolationswächter mit elektronischer Analogschaltung zur Anwendung des Verfahrens gemäß einem der Ansprüche 1 bis 5, bestehend aus:
   - einem Generator G zur Injizierung eines Wechselstrom-Referenzssignals zwischen Leitungsnetz und Erde,
   - einem Differenzstrom-Ringkernwandler (12) mit einer Meßwicklung (14), die ein dem über die Fehlerimpedanz Zd fließenden Fehlerstrom Id proportionales Meßsignal Vd liefert,
   - einer Synchron-Meßschaltung (18) zur Bestimmung der Wirkkomponente und der kapazitiven Blindkomponente des genannten Meßsignals
   - und einer Rechen- und Anzeigeeinheit (20), die die Werte für den Fehlerwiderstand R und die Störkapazität C des Leitungsnetzes anzeigt, dadurch gekennzeichnet, daß die elektronische Analogschaltung folgende Schaltungen kombiniert:
   - einen Meßkreis (22), der parallel an die Klemmen der Meßwicklung (14) des Ringkernwandlers (12) angeschlossen ist und einen Lastwiderstand r aufweist, der mit einem ersten, durch einen Zähler H angesteuerten elektronischen Schalter (24) zusammenwirkt, um die Leerlaufspannung und die Last-

8

spannung des Meßsignals Vd zu messen,
- eine Schaltung 28 zur Berechnung der Phasenverschiebung, die zur Bestimmung des Tangens des Phasenverschiebungswinkels A die Lastspannung und die Leerlaufspannung des Meßsignals Vd ins Verhältnis setzt,
- und eine Kompensationsschaltung (30), die zur Korrektur der durch den Ringkernwandler (12) im Leitungsnetz verursachten Phasenverschiebung A mit der Schaltung (28) zur Berechnung der Phasenverschiebung und mit der Synchron-Meßschaltung (18) zusammenwirkt.

7. Isolationswächter nach Anspruch 6, dadurch gekennzeichnet, daß ein Verstärker (16) mit veränderbarem Verstärkungsfaktor zwischen den Meßkreis (22) und ein Filter (32) zur Unterdrückung der Netzfrequenz geschaltet wird, wobei die Einstellung des Verstärkungsfaktors mit Hilfe eines zweiten, über den Zähler H angesteuerten elektronischen Schalters (26) erfolgt, und die Schaltung (28) zur Berechnung der Phasenverschiebung folgende Komponenten umfaßt:
- einen zwischen das Filter (32) und einen ersten Eingang eines Dividierers (36) geschalteten Wechselspannungs-Gleichpannungs-Umrichter (34)
- und ein erstes, über den Zähler H angesteuertes und zwischen den Ausgang des Umrichters (34) und einen zweiten Eingang des Dividierers (36) geschaltetes Speicherglied M1, wobei der Ausgang des Dividierers ein den Tangens des Phasenverschiebungswinkels A abbildendes Signal U3 liefert.

8. Isolationswächter nach Anspruch 7, dadurch gekennzeichnet, daß die Kompensationsschaltung (30) folgende Komponenten umfaßt:
- einen Multiplizierer (38), der mit dem Ausgangssignal U3 des Dividierers (36) sowie mit der kapazitiven Blindkomponente UC der Synchron-Meßschaltung (18) beaufschlagt wird,
- einen Addierer (40), dem das Ausgangssignal des Multiplizierers (38) und die Wirkkomponente UR der Synchron-Meßschaltung (18) zugeführt wird,
- und ein zweites, über den Zähler H angesteuertes Speicherglied M2 zur Speicherung der tatsächlichen Wirkkomponente UR1 nach erfolgter Phasenkorrektur.

9. Isolationswächter mit elektronischer Digitalschaltung zur Anwendung des Verfahrens gemäß einem der Ansprüche 1 bis 5, bestehend aus einer digitalen Mikroprozessorsteuerung P2 zur Bestimmung des Fehlerwiderstands R und der Störkapazität C eines Leitungsnetzes mit Hilfe eines von einem Differenzstrom-Ringkernwandler (64, 66, 68) gelieferten Meßsignals, dadurch gekennzeichnet, daß die elektronische Digitalschaltung folgende Komponenten umfaßt:
- einen Meßkreis (74) mit einem Relais (76) zur Umschaltung zwischen einem Leerlaufwiderstand Ro und einem Lastwiderstand R1,
- einen Signalprozessor P1 zur Ansteuerung des Relais (76), um eine Messung des vom Ringkernwandler (64, 66, 68) gelieferten Signals im Leerlauf und unter Last sowie eine anschließende Demodulation durchzuführen
- eine elektronische Verriegelungsschaltung (82) zur Übertragung der Daten des Prozessors P1 an die Mikroprozessorsteuerung, die den Tangens des durch den genannten Ringkernwandler verursachten Phasenverschiebungswinkels A sowie die tatsächlichen Werte für den Fehlerwiderstand R und die Störkapazität C berechnet, wobei der Meßkreis (74) zwischen einen an die Ringkernwandler (64, 66, 68) mehrerer Abgänge (52, 54, 56) angeschlossenen Analog-Multiplexer (70) und einen Verstärker (72) mit veränderbarem Verstärkungsfaktor geschaltet ist, welcher über ein Filter (78) zur unverfälschten Spektrumsübertragung und eine einem Analog-Digital-Umsetzer CAN zugeordnete Abtast-Blockierschaltung (80) mit dem Signalprozessor P1 verbunden ist.

10. Isolationswächter nach Anspruch 9, dadurch gekennzeichnet, daß die Schaltung ein Ohmmeter umfaßt, das mit dem Umschaltrelais (76) zusammenwirkt, um den ohmschen Widerstand der Meßwicklung des zugeordneten Differenzstrom-Ringkernwandlers (64, 66, 68) zu messen.


## Claims

1. A procedure for measuring an earth leakage current for monitoring of the isolation of an electrical power distribution system, consisting in :
- continuously injecting a reference AC signal between the power system and ground,
- taking a measurement signal Vd proportional to the leakage current Id flowing in the leakage impedance Zd at the terminals of a measurement winding of a differential transformer with a toroid surrounding the power system conductors,
- analyzing the measurement signal in phase and amplitude by synchronous detection or demodulation to discriminate between the resistive and capacitive components,
- computing and displaying the individual values of the leakage resistance R and of the stray capacitance C of the power system responsible for the leakage current Id,
  characterized by the following intermediate stages :
- the no-load voltage and the load voltage of the measurement signal Vd delivered by the differential transformer are measured,
- the phase difference introduced by the toroid between the leakage current Id and the measurement signal Vd is determined on-line, by dividing the amplitude of the load voltage by the amplitude of the no-load voltage enabling a predetermined ratio assimilated to the tangent of the angle of phase difference to be obtained,
- a phase correction is performed on the resistive and capacitive components by means of said ratio to obtain the true phase of the leakage current Id, and the true values of the leakage resistance R and of the stray capacitance C.

2. The measuring procedure according to claim 1, characterized in that division of the load and no-load voltage amplitudes of the differential transformer measurement signal is performed periodically so as to obtain an evolution of phase difference angle of the toroid over time.

3. The measuring procedure according to claim 1 or 2, characterized in that synchronous detection is performed by means of two control signals C1 and C2 in phase quadrature, one of these signals C1 being in phase with the input reference AC signal, and that phase correction is performed after synchronous detection by an angle rotation of the resistive and capacitive components.

4. The measuring procedure according to one of the claims 1 to 3, characterized in that phase correction is performed by adding to the resistive component of the measurement signal, a first corrected quantity corresponding to the product of the capacitive component of said measurement signal by the tangent of the angle of phase difference A.

5. The measuring procedure according to one of the claims 1 to 3, characterized in that angle correction is performed by subtracting from the capacitive component of the measurement signal after synchronous detection, a second corrected quantity corresponding to the product of the resistive component of said measurement signal by the tangent of the angle of phase difference A.

6. An isolation monitor having an analog electronic circuit for implementation of the procedure according to one of the claims 1 to 5, comprising :
   - a generator G injecting a reference AC signal between the power system and ground,
   - a differential transformer with a zero sequence toroid (12) having a measurement winding (14) which delivers a measurement signal Vd proportional to the leakage current Id flowing in the leakage impedance Zd,
   - a synchronous detector device (18) to discriminate between the resistive and capacitive components of said measurement signal,
   - and a computing and display device (20) which indicates the values of the leakage resistance R and of the stray capacitance C of the power system, characterized in that the analog electronic circuit comprises in addition in combination :
   - a measuring circuit (22) connected in parallel to the terminals of the measurement winding (14) of the toroid (12), and comprising a load resistor r cooperating with a first static switch (24) controlled by a timer H, to measure the no-load voltage and the load voltage of the measurement signal Vd,
   - a phase difference computation circuit (28) computing the relationship between the load voltage and the no-load voltage to determine the tangent of the angle of phase difference A,
   - and a compensating circuit (30) cooperating with the phase difference computation circuit (28) and the synchronous detector device (18) to correct the phase difference A introduced on-line by the toroid (12).

7. The isolation monitor according to claim 6, characterized in that a variable gain amplifier (16) is connected between the measuring circuit (22) and a filter (32) eliminating the power system frequency, programming of the gain being performed by means of a second static switch (26) controlled by the timer H, and that the phase difference computation circuit (28) comprises:
- an AC-DC converter (34) connected between the filter (32) and a first input of a dividing circuit (36),
- and a first memory circuit M1 controlled by the timer H and connected between the output of the converter (34) and a second input of a dividing circuit (36), the output of the latter delivering a signal U3 representative of the tangent of the angle of phase difference A.

8. The isolation monitor according to claim 7, characterized in that the compensating circuit (30) comprises :
- a multiplier circuit (38) sensitive to the output signal U3 of the dividing circuit (36), and to the capacitive component UC of the synchronous detector device (18),
- an adder circuit (40) receiving the output signal of the multiplier circuit (38) and the resistive component UR of the synchronous detector device (18),
- and a second memory circuit M2 controlled by the timer H to store the true resistive component after phase correction.

9. An isolation monitor having a digital electronic circuit for implementation of the procedure according to one of the claims 1 to 5, comprising a digital microcontroller P2 to determine the leakage resistance R and the stray capacitance C of a power system from a measurement signal from a differential transformer with a zero sequence toroid (64, 66, 68),
characterized in that the digital electronic circuit comprises :
- a measuring circuit (74) equipped with a selector relay (76) for selecting a no-load resistor R0 and a load resistor R1,
- a signal processor P1 controlling the relay (76) to perform a no-load and an on-load measurement of the signal delivered by the toroid (64, 66, 68) followed by synchronous demodulation,
- an electronic latch (82) to enable data to be transmitted from the processor P1 to the microcontroller which performs computation of the tangent of the angle of phase difference A introduced by said toroid, and of the true values of the leakage resistance R and of the stray capacitance C, the measuring circuit (74) being connected between an analog multiplexer circuit (70) connected to the toroids (64, 66, 68) of several feeders (52, 54, 56), and a variable gain amplifier (72) connected to the signal processor P1 by means of a spectrum anti-aliasing filter (78) and a sample-and-hold circuit (80) associated with an analog-to-digital converter CAN.

10. The isolation monitor according to claim 9, characterized in that the circuit comprises an ohmmeter cooperating with the selector relay (76) to measure the electrical resistance of the measurement winding of the associated zero sequence differential transformer (64, 66, 68).

Fig 1

Fig 2

Fig 3

50

EP 0 399 923 B1

14

Fig 4